# EUROPÄISCHE PATENTSCHRIFT

(11) **EP 3 206 944 B1**
(45) Veröffentlichungstag und Bekanntmachung des Hinweises auf die Patenterteilung: **13.11.2019**
(21) Anmeldenummer: 15771959.2
(22) Anmeldetag: 30.09.2015
(51) Int. Cl.: B63B 43/00, B63G 13/00, F41J 5/04

(54) **MESSVORRICHTUNG UND VERFAHREN ZUR ERFASSUNG EINES SCHADENS IN DER AUSSENHAUT EINES FAHRZEUGS UND WASSERFAHRZEUG**
MEASURING DEVICE AND METHOD FOR DETECTING DAMAGE IN THE OUTER SKIN OF A VEHICLE AND A WATERCRAFT
DISPOSITIF DE MESURE ET PROCÉDÉ DE DÉTECTION D'UN DOMMAGE DANS L'ENVELOPPE EXTÉRIEURE D'UN VÉHICULE ET BATEAU

(30) Priorität: 13.10.2014 DE 102014114789
(43) Veröffentlichungstag der Anmeldung: 23.08.2017
(73) Patentinhaber: thyssenkrupp Marine Systems GmbH, 24143 Kiel (DE); thyssenkrupp AG, 45143 Essen (DE)
(72) Erfinder: DETERMANN, Wolfram, 22851 Norderstedt (DE)
(74) Vertreter: thyssenkrupp Intellectual Property GmbH
(86) Internationale Anmeldenummer: PCT/EP2015/072586
(87) Internationale Veröffentlichungsnummer: WO 2016/058832

(56) Entgegenhaltungen:
- WO-A2-2006/028490
- DE-A1-102010 054 754
- GB-A- 2 435 519

## Beschreibung

### Stand der Technik

Die vorliegende Erfindung betrifft eine Messvorrichtung zur Erfassung eines Schadens in einer Außenhaut eines Fahrzeugs, insbesondere eines Wasserfahrzeugs, mit einem an der Außenhaut des Fahrzeugs anordbaren Sensorelement, welches einen gegenüber der Außenhaut isolierten Hinleiter aufweist. Ein weiterer Gegenstand der Erfindung ist ein Wasserfahrzeug mit einer derartigen Messvorrichtung. Die Erfindung betrifft ferner ein Verfahren zur Erfassung eines Schadens in einer Außenhaut eines Fahrzeugs, insbesondere eines Wasserfahrzeugs, wobei an der Außenhaut des Fahrzeugs ein Sensorelement angeordnet wird, welches einen gegenüber der Außenhaut isolierten Hinleiter aufweist.

Derartige Messvorrichtungen werden bei Fahrzeugen im militärischen Einsatzbereich, insbesondere bei militärischen Wasserfahrzeugen, eingesetzt, um Schäden an der Außenhaut erfassen zu können. Beispielsweise ist aus der DE 10 2010 054 754 A1 ein militärisches Wasserfahrzeug bekannt, bei dem an der Außenhaut mehrere Sensorelemente angeordnet sind. Die Sensorelemente dieses Wasserfahrzeugs weisen einen elektrischen Hinleiter und einen elektrischen Rückleiter auf, welche gegeneinander sowie gegenüber der Außenhaut isoliert sind. Bei einem Schaden in der Außenhaut infolge einer Geschoss- oder Explosionseinwirkung kommt es zu einer lokalen Zerstörung der Isolation zwischen dem Hinleiter und dem Rückleiter, so dass ein Kurzschluss zwischen dem Hinleiter und dem Rückleiter detektiert werden kann.

Aus der WO 2006/028490 A2 eine Vorrichtung zur Bestimmung von Positionsinformationen mit horizontalen und vertikalen Linien aus leitfähigem Material bekannt.

Aus der GB 2 435 519 A ist ein System zur Schadensdetektion mit einer Kapazität und einem Spannungsmessgerät, welches die Spannung der Kapazität erfasst, bekannt.

Die bekannte Messvorrichtung ermöglicht die verlässliche Erfassung von Außenhautschäden und hat sich im Einsatz durchaus bewährt. Allerdings wäre es wünschenswert, die Herstellungskosten der Messvorrichtung zu reduzieren und den Aufwand bei der Installation der Messvorrichtung zu reduzieren.

### Offenbarung der Erfindung

Die Aufgabe der vorliegenden Erfindung ist es, die Kosten und den Installationsaufwand zur Erfassung von Schäden in der Außenhaut zu verringern.

Gelöst wird die Aufgabe durch eine Messvorrichtung zur Erfassung eines Schadens in einer Außenhaut eines Fahrzeugs, insbesondere eines Wasserfahrzeugs, mit einem an der Außenhaut des Fahrzeugs anordbaren Sensorelement, welches einen gegenüber der Außenhaut isolierten Hinleiter aufweist, wobei das Sensorelement rückleiterlos ausgebildet ist.

Zur Lösung der Aufgabe trägt ferner ein Verfahren zur Erfassung eines Schadens in einer Außenhaut eines Fahrzeugs, insbesondere eines Wasserfahrzeugs, bei, wobei an der Außenhaut des Fahrzeugs ein Sensorelement angeordnet wird, welches einen gegenüber der Außenhaut isolierten Hinleiter aufweist und wobei ein elektrischer Strom zwischen dem Hinleiter und der Außenhaut gemessen wird.

Bei einem durch Geschoss- oder Explosionseinwirkung verursachten Schaden in der Außenhaut kann es zu der zumindest teilweisen Zerstörung der Isolation des Hinleiters gegenüber der Außenhaut kommen, so dass sich der elektrische Widerstand zwischen dem Hinleiter und der Außenhaut verringert. Zur Erfassung des Schadens wird der zwischen dem Hinleiter und der Außenhaut fließende elektrische Strom gemessen. Es ist daher nicht erforderlich, einen Rückleiter in dem Sensorelement vorzusehen und einen Strom zwischen dem Hinleiter und dem Rückleiter zu messen. Durch die rückleiterlose Ausbildung des Sensorelements weist das Sensorelement einen einfachen Aufbau auf. Bei der Installation des Sensorelements entfällt der Aufwand zur Verkabelung des Rückleiters. Durch das erfindungsgemäße Sensorelement reduzieren sich somit die Herstellungs- und Installationskosten.

Bevorzugt weist das Sensorelement genau einen elektrischen Leiter, nämlich den Hinleiter, auf. Durch eine Ausgestaltung, bei der außer dem Hinleiter kein weiterer elektrischer Leiter in dem Sensorelement vorhanden ist, wird ein besonders kompakter Aufbau des Sensorelements ermöglicht.

Erfindungsgemäß ist der Hinleiter flächig ausgebildet ist, wodurch es möglich wird, einen großen sensitiven Bereich bereitzustellen. Bevorzugt kann das Sensorelement über der gesamten Fläche des Hinleiters Beschädigungen der Außenhaut detektieren. Der Hinleiter kann als eine Lage aus elektrisch leitfähigem Material, beispielsweise aus Kohlenstofffasern oder aus einem Metall wie etwa Aluminium oder Kupfer, ausgebildet sein. Alternativ oder zusätzlich kann der Hinleiter ein Netz und/oder ein Gewebe aus einem leitfähigen Material aufweisen, z. B. eine Aluminium-Gaze, Niro-Gaze oder einen leitfähigen Kunststoff, wie beispielsweise Polyanilin oder Carbon (kohlenstofffaserverstärkter Kunststoff). Insbesondere kann auch ein mit Kohlenstoffnanoröhrchen versetzter Kunststoff verwendet werden, da dieser bei einem sehr geringen Kohlenstoffanteil bereits leitfähig ist und praktisch wie der Basiskunststoff verarbeitbar ist.

Erfindungsgemäß ist der Hinleiter zwischen zwei elektrisch isolierenden Lagen angeordnet, so dass der Hinleiter sowohl gegenüber der Außenhaut als auch gegenüber der Umgebung elektrisch isoliert ist. Die elektrisch isolierenden Lagen können beispielsweise aus Polyethylen, Ethylen-Propylen-Dien-Kautschuk, Neopren, Glasfasern, Aramidfasern und/oder als biaxial orientierte Polyester-Folie, z.B. Mylar®-Folie, ausgebildet sein. Bevorzugt ist der Hinleiter unmittelbar mit den beiden isolierenden Lagen verbunden, beispielsweise durch Kleben, Bedampfen, Drucken und/oder Vulkanisieren.

Vorteilhaft ist eine Ausgestaltung, bei welcher der Hinleiter mit einer Detektionseinrichtung verbunden ist, über die ein Stromfluss zwischen dem Hinleiter und der Außenhaut detektierbar ist. Die Detektionseinrichtung kann beispielsweise als Fehlerstromdetektor ausgebildet sein. Durch die Detektion eines Stromflusses kann auf einen verringerten elektrischen Widerstand zwischen dem Hinleiter und der Außenhaut geschlossen werden.

Besonders vorteilhaft ist es, wenn die Detektionseinrichtung mit einem Schadenskontrollsystem des Fahrzeugs verbunden ist, so dass bei Detektion einer Beschädigung eine Meldung an das Schadenskontrollsystem generiert werden kann. Bevorzugt erfolgt die Anbindung der Detektionseinrichtung an das Schadenskontrollsystem über ein Netzwerkmodul.

Ein weiterer Gegenstand der Erfindung ist ein, insbesondere militärisches, Wasserfahrzeug mit einer vorstehend beschriebenen Messvorrichtung. Bei dem erfindungsgemäßen Wasserfahrzeug ergeben sich dieselben Vorteile, wie sie bereits im Zusammenhang mit der Messvorrichtung erläutert worden sind.

Vorteilhafterweise ist die Außenhaut des Wasserfahrzeugs aus einem elektrisch leitfähigen Material ausgebildet.

Eine bevorzugte Ausgestaltung sieht vor, dass das Sensorelement an der Innenseite der Außenhaut des Wasserfahrzeugs aufgeklebt ist, wodurch eine belastbare Verbindung des Sensorelements mit der Außenhaut ermöglicht wird.

Bei dem Wasserfahrzeug können auch die im Zusammenhang mit der Messvorrichtung beschriebenen vorteilhaften Merkmale allein oder in Kombination Verwendung finden.

Zusätzlich zur Detektion eines Stromflusses kann über das Messsystem auch eine kapazitive Messung erfolgen. Der, insbesondere flächige, Hinleiter und die Außenhaut des Fahrzeugs bilden einen Plattenkondensator. Sollte ein Treffer den Hinleiter derart durchtrennen, dass kein Kontakt zwischen dem Hinleiter und der Außenhaut entsteht, z. B. wenn der Treffer die Zuleitung des Hinleiters beschädigt, so kann zwar kein Strom, jedoch eine deutliche Veränderung der Kapazität gemessen werden. Hierdurch kann die Zuverlässigkeit des Systems weiter gesteigert werden.

Weitere Einzelheiten, Merkmale und Vorteile der Erfindung ergeben sich aus den Zeichnungen, sowie aus der nachfolgenden Beschreibung von bevorzugten Ausführungsformen anhand der Zeichnungen. Die Zeichnungen illustrieren dabei lediglich beispielhafte Ausführungsformen der Erfindung, welche den Erfindungsgedanken nicht einschränken.

### Kurze Beschreibung der Figuren

Die **Figur 1** zeigt die Außenhaut eines Wasserfahrzeugs mit einer erfindungsgemäßen Messvorrichtung in einer perspektivischen Darstellung.
Die **Figur 2** zeigt ein Sensorelement in einer schematischen Darstellung.
Die **Figur 3** zeigt ein Blockschaltbild einer Messvorrichtung gemäß der Erfindung.

### Ausführungsformen der Erfindung

In den verschiedenen Figuren sind gleiche Teile stets mit den gleichen Bezugszeichen versehen und werden daher in der Regel auch jeweils nur einmal benannt bzw. erwähnt.

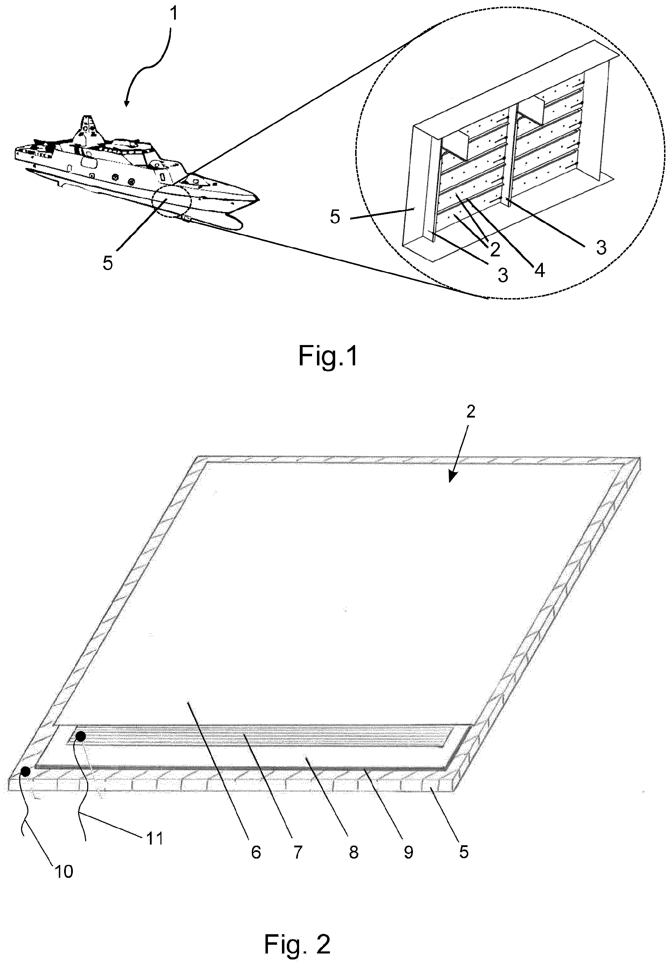

In der **Figur 1** ist ein als militärisches Wasserfahrzeug ausgebildetes Fahrzeug 1 dargestellt. Das Wasserfahrzeug 1 weist eine aus Stahl ausgebildete Außenhaut 5 auf. Abweichend von diesem Ausführungsbeispiel kann die Außenhaut 5 aus einem anderen, zumindest schwach elektrisch leitfähigen Material ausgebildet sein.

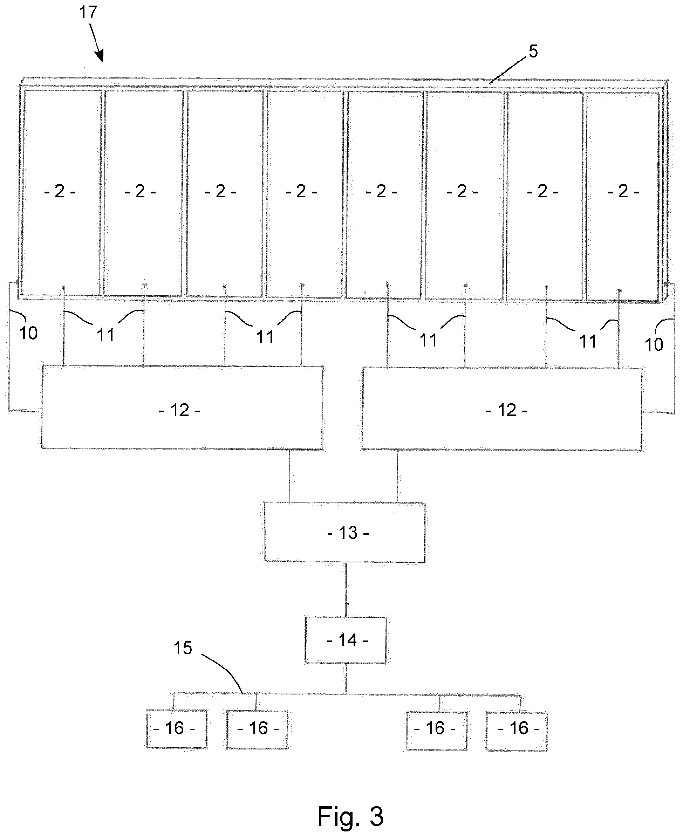

Das Wasserfahrzeug 1 weist eine in **Figur 3** dargestellte Messvorrichtung 17 zur Erfassung eines Schadens in der Außenhaut 5 auf, die es ermöglicht, schnell und zielgenau Maßnahmen zur Behebung des Schadens in die Wege zu leiten. Solche Schäden können beispielsweise durch eine Kollision des Wasserfahrzeugs 1 mit einem Hindernis oder durch die Einwirkung von Geschossen und/oder Druckwellen von Sprengladungen entstehen. Die Messvorrichtung 17 weist eine Vielzahl von Sensorelementen 2 auf, welche an der Innenseite der Außenhaut 5 des Wasserfahrzeugs 1 angeordnet sind. Die **Figur 1** zeigt in einer vergrößerten Darstellung beispielhaft eine Anordnung, bei welcher mehrere Sensorelemente 2 zwischen Querspanten 3 und Längsspanten 4 einer Außenhaut 5 angeordnet sind. Die Sensorelemente 2 sind innen auf die Außenhaut 5 aufgeklebt.

Wie der Darstellung in **Figur 2** zu entnehmen ist, weist das Sensorelement 2 der in **Figur 3** dargestellten Messvorrichtung 17 einen folienartigen Aufbau auf. Das Sensorelement 2 ist erfindungsgemäß als dreischichtiger Foliensensor ausgebildet, welcher über einen, bevorzugt leitfähigen, Kleber 9 mit der Innenseite Außenwand 5 verbunden ist. Auf einer zur Verbindung mit der Außenwand bestimmten Außenseite des Sensorelements 2 weist das Sensorelement 2 eine erste Isolatorschicht 8 auf. Mit der ersten Isolatorschicht 8 ist eine elektrisch leitfähige Leiterschicht verbunden, die den flächigen Hinleiter 7 des Sensorelements 2 bildet. Der Hinleiter 7 wird somit durch die erste Isolatorschicht 8 gegenüber der Außenhaut 5 isoliert. Auf einer der ersten Isolatorschicht 8 gegenüberliegenden Seite des Hinleiters 7 ist eine zweite Isolatorschicht 6 angeordnet, welche den Hinleiter 7 gegenüber der Umgebung isoliert. Das Sensorelement 2 weist somit nur einen einzigen elektrischen Leiter 7 auf und ist insofern rückleiterlos ausgebildet. Die rückleiterlose Ausgestaltung des Sensorelements 2 hat sich als besonders vorteilhaft im Hinblick auf die Fertigung und die Installation des Sensorelements 2 herausgestellt. Denn im Rahmen der Herstellung des Sensorelements 2 kann auf eine weitere elektrisch leitfähige Lage zusätzlich zu dem Hinleiter 7 verzichtet werden. Der rückleiterlose Aufbau des Sensorelements 2 bietet auch Vorteile bei der Installation des Sensorelements 2 an der Außenhaut 5. Denn wie der Darstellung in Figur 2 entnommen werden kann, muss das Sensorelement 2 nur mit einer Leitung 11 kontaktiert werden, welche mit dem Hinleiter 7 verbunden wird. Weitere elektrische Kontaktierungen des Sensorelements 2 sind nicht erforderlich. Zur Detektion von Schäden wird die Außenhaut 5 über eine Leitung 10 kontaktiert. Sofern das Wasserfahrzeug 1 bereits einen Masseanschluss für die Außenhaut 5 aufweist, kann der Masseanschluss verwendet werden, so dass keine weiteren elektrischen Verkabelungen vorgesehen werden müssen.

Die Isolatorschichten 6, 8 sind aus einem elektrisch isolierenden Material, wie beispielsweise Polyethylen, Ethylen-Propylen-Dien-Kautschuk, Neopren, Glasfasern, Aramidfasern und/oder biaxial orientierte Polyester-Folie, z. B. Mylar®-Folie, ausgebildet. Der Hinleiter 7 ist aus einem elektrisch leitfähigen Material gefertigt, z. B. aus Aluminium oder Kupfer. Alternativ oder zusätzlich kann der Hinleiter 7 ein Netz und/oder ein Gewebe aus einem leitfähigen Material aufweisen, z. B. eine Aluminium-Gaze, Niro-Gaze oder einen leitfähigen Kunststoff, wie beispielsweise Polyanilin oder Carbon (kohlenstofffaserverstärkter Kunststoff).

Bei einem Schaden in der Außenhaut 5 kommt es in der Regel auch zu einer zumindest teilweisen Zerstörung der zwischen der Außenhaut 5 und dem Hinleiter 7 angeordneten ersten Isolatorschicht 8, welche eine Verringerung des ohmschen Widerstands zwischen dem Hinleiter 7 und der Außenhaut 5 zur Folge hat. Die Detektion solcher Widerstandänderungen erfolgt mittels einer mit dem Sensorelement 2 über die Leitungen 10, 11 verbundenen Detektionseinrichtung 12. Wie in der **Figur 3** dargestellt, kann eine solche Detektionseinrichtung 12 mit mehreren Sensorelementen verbunden sein. Zur Erfassung eines Schadens wird zwischen der Sensorfolie 2 und der Außenhaut 5 eine, bevorzugt gepulste, Messspannung angelegt. Bei angelegter Messspannung wird der elektrische Strom zwischen dem Hinleiter 7 und der Außenhaut 5 gemessen. Übersteigt der gemessene Strom einen vorgegebenen Maximalwert, so wird von der Detektionseinrichtung 12 ein Schadensignal erzeugt. Das Schadensignal wird von der Detektionseinrichtung 12 an eine mit der Detektionseinrichtung 12 verbundene Auswerteeinheit 13 weitergeleitet, welche den Schaden einem Bereich der Außenkontur zuordnet. In der Auswerteeinheit 13 wird ein Datenpaket generiert, welches eine Ortungsinformation enthält, die von einem Schadenskontrollsystem 15, 16 des Fahrzeugs eingelesen werden kann. Das Schadenskontrollsystem wird im vorliegenden Beispiel durch ein Netzwerk 1 gebildet, an welches mehrere Kontrollstationen 16 angebunden sind. Die Weitergabe des Datenpakets von der Auswerteeinheit 13 an das Schadenskontrollsystem erfolgt über ein Netzwerkmodul 14.

Das vorstehend beschriebene Wasserfahrzeug 1 weist eine Messvorrichtung 17 zur Erfassung eines Schadens in der Außenhaut des Wasserfahrzeug 1 auf, wobei die Messvorrichtung 17 ein an einer Außenhaut 5 des Wasserfahrzeugs 1 angeordnetes Sensorelement 2 umfasst, welches einen gegenüber der Außenhaut 5 isolierten Hinleiter 7 aufweist und rückleiterlos ausgebildet ist. Bei dem vorstehend beschriebenen Verfahren zur Erfassung eines Schadens in der Außenhaut 5 des Wasserfahrzeugs 1 wird an der Außenhaut 5 ein Sensorelement 2 angeordnet, welches einen gegenüber der Außenhaut isolierten Hinleiter 7 aufweist und es wird ein elektrischer Strom zwischen dem Hinleiter 7 und der Außenhaut 5 gemessen.

### Bezugszeichenliste

- 1: Wasserfahrzeug
- 2: Sensorelement
- 3: Querspant
- 4: Längsspant
- 5: Außenhaut
- 6: Isolator
- 7: Hinleiter
- 8: Isolator
- 9: Kleber
- 10: Zuleitung
- 11: Zuleitung
- 12: Detektionseinrichtung
- 13: Auswerteeinheit
- 14: Netzwerkmodul
- 15: Netzwerk
- 16: Kontrollstation
- 17: Messvorrichtung

## Patentansprüche

1. Messvorrichtung zur Erfassung eines Schadens in einer Außenhaut (5) eines Fahrzeugs, insbesondere eines Wasserfahrzeugs (1), mit einem an der Außenhaut (5) des Fahrzeugs anordbaren Sensorelement (2), welches einen gegenüber der Außenhaut (5) isolierten Hinleiter (7) aufweist, **dadurch gekennzeichnet,**
**dass** das Sensorelement (2) rückleiterlos ausgebildet ist, wobei der Hinleiter (7) flächig ausgebildet ist, wobei der Hinleiter (7) zwischen zwei elektrisch isolierenden Lagen (6, 8) angeordnet ist, wobei das Sensorelement (2) als dreischichtiger Foliensensor ausgebildet ist.

2. Messvorrichtung nach Anspruch 1, wobei der Hinleiter (7) mit einer Detektionseinrichtung (12) verbunden ist, über welche ein Stromfluss zwischen dem Hinleiter (7) und der Außenhaut (5) detektierbar ist.

3. Messvorrichtung nach Anspruch 2, wobei die Detektionseinrichtung (12) ist mit einem Schadenskontrollsystem (15, 16) des Fahrzeugs verbunden ist.

4. Wasserfahrzeug (1) mit einer Messvorrichtung (17) nach einem der Ansprüche 1 bis 3.

5. Wasserfahrzeug nach Anspruch 4, wobei das Sensorelement (2) an der Innenseite der Außenhaut (5) des Wasserfahrzeugs (1) aufgeklebt ist.

6. Verfahren zur Erfassung eines Schadens in einer Außenhaut (5) eines Fahrzeugs, insbesondere eines Wasserfahrzeugs (1), wobei an der Außenhaut (5) des Fahrzeugs ein Sensorelement (2) angeordnet wird, welches einen gegenüber der Außenhaut (5) isolierten Hinleiter (7) aufweist, **dadurch gekennzeichnet,**
**dass** ein elektrischer Strom zwischen dem Hinleiter (7) und der Außenhaut (5) gemessen wird, wobei der Hinleiter (7) flächig ausgebildet ist, wobei der Hinleiter (7) zwischen zwei elektrisch isolierenden Lagen (6, 8) angeordnet ist, wobei das Sensorelement (2) als dreischichtiger Foliensensor ausgebildet ist.

7. Verwendung einer Messvorrichtung (12) nach einem der Ansprüche 1 bis 3 zur Erfassung von Beschussschäden an einem Wasserfahrzeug (1).

## Claims

1. Measuring device for detecting damage in an outer skin (5) of a vehicle, in particular of a watercraft (1), having a sensor element (2), which comprises a forward conductor (7) which is insulated with respect to the outer skin (5), and which can be arranged on the outer skin (5) of the vehicle, **characterized in that** the sensor element (2) is embodied without a return conductor, wherein the forward conductor (7) is embodied in a planar fashion, wherein the forward conductor (7) is arranged between two electrically insulating layers (6, 8), wherein the sensor element (2) is embodied as a three-layered film sensor.

2. Measuring device according to Claim 1, wherein the forward conductor (7) is connected to a detection device (12) via which a flow of current between the forward conductor (7) and the outer skin (5) can be detected.

3. Measuring device according to Claim 2, wherein the detection device (12) is connected to a damage monitoring system (15, 16) of the vehicle.

4. Watercraft (1) having a measuring device (17) according to one of Claims 1 to 3.

5. Watercraft according to Claim 4, wherein the sensor element (2) is bonded onto the inner side of the outer skin (5) of the watercraft (1).

6. Method for detecting damage in an outer skin (5) of a vehicle, in particular of a watercraft (1), wherein a sensor element (2), which comprises a forward conductor (7) which is insulated with respect to the outer skin (5), is arranged on the outer skin (5) of the vehicle, **characterized in that** an electrical current between the forward conductor (7) and the outer skin (5) is measured, wherein the forward conductor (7) is embodied in a planar fashion, wherein the forward conductor (7) is arranged between two electrically insulating layers (6, 8), wherein the sensor element (2) is embodied as a three-layered film sensor.

7. Use of a measuring device (12) according to one of Claims 1 to 3 for detecting bombardment damage to a watercraft (1).

## Revendications

1. Dispositif de mesure destiné à détecter un dommage dans une enveloppe extérieure (5) d'un véhicule, en particulier d'un véhicule nautique (1), comprenant un élément capteur (2) qui peut être disposé sur l'enveloppe extérieure (5) du véhicule et qui comporte un conducteur aller (7) isolé par rapport à l'enveloppe extérieure (5), **caractérisé en ce que** l'élément capteur (2) est réalisé sans conducteur retour, dans lequel le conducteur aller (7) est réalisé sous forme plate, dans lequel le conducteur aller (7) est disposé entre deux couches électriquement isolantes (6, 8), dans lequel l'élément capteur (2) est réalisé sous la forme d'un capteur de type film à trois couches.

2. Dispositif de mesure selon la revendication 1, dans lequel le conducteur aller (7) est relié à un moyen de détection (12) par l'intermédiaire duquel un flux de courant peut être détecté entre le conducteur aller (7) et l'enveloppe extérieure (5).

3. Dispositif de mesure selon la revendication 2, dans lequel le moyen de détection (12) est relié à un système de contrôle de dommage (15, 16) du véhicule.

4. Véhicule nautique (1) comprenant un dispositif de mesure (17) selon l'une des revendications 1 à 3.

5. Véhicule nautique selon la revendication 4, dans lequel l'élément capteur (2) est collé à la face intérieure de l'enveloppe extérieure (5) du véhicule nautique (1).

6. Procédé destiné à détecter un dommage dans une enveloppe extérieure (5) d'un véhicule, en particulier d'un véhicule nautique (1), dans lequel il est prévu, sur l'enveloppe extérieure (5) du véhicule, un élément capteur (2) qui comporte un conducteur aller (7) isolé par rapport à l'enveloppe extérieure (5), **caractérisé en ce qu'**un courant électrique est mesuré entre le conducteur aller (7) et l'enveloppe extérieure (5), dans lequel le conducteur aller (7) est réalisé sous forme plate, dans lequel le conducteur aller (7) est disposé entre deux couches électriquement isolantes (6, 8), dans lequel l'élément capteur (2) est réalisé sous la forme d'un capteur de type film à trois couches.

7. Utilisation d'un dispositif de mesure (12) selon l'une des revendications 1 à 3 pour détecter des dommages dus à des tirs sur un véhicule nautique (1).
